# EUROPEAN PATENT SPECIFICATION

(11) **EP 0 399 661 B1**
(45) Date of publication and mention of the grant of the patent: **16.09.1998**
(21) Application number: 90304415.4
(22) Date of filing: 25.04.1990
(51) Int. Cl.: H01L 23/498, H01L 23/64, H05K 1/02, H05K 1/14

(54) **Integrated circuit lead assembly structure**
Leiterstruktur für eine integrierte Schaltung
Structure d'assemblage de conducteurs pour circuit intégré

(30) Priority: 22.05.1989 US 354647
(43) Date of publication of application: 28.11.1990
(73) Proprietor: ADVANCED MICRO DEVICES, INC., Sunnyvale, CA 94088-3453 (US)
(72) Inventor: Tsung-Chen Mu, Albert, San Jose, California 95123 (US)
(74) Representative: Sanders, Peter Colin Christopher

(56) References cited:
- EP-A- 26 807
- EP-A- 166 289
- EP-A- 198 621
- EP-A- 262 493
- EP-A- 262 780
- GB-A- 2 207 558
- JP-A- 1 042 158
- IBM TECHNICAL DISCLOSURE BULLETIN. vol. 20, no. 8, January 1978, NEW YORK US pages 3092 - 3093; M.E. ECKER ET AL.: 'Semiconductor package structure'

## Description

This invention relates to improved packaging for integrated circuit structures. More particularly, this invention relates to an improved lead assembly for an integrated circuit structure to reduce crosstalk and coupling and provide additional improvements.

In the conventional packaging of integrated circuit structures with traditional leadframe patterns, the die may be attached to the center paddle of a metal lead frame which has a plurality of metal leads which fan out from a series of bonding pads arranged around the four sides of the die. The respective widths of these leads may vary along their lengths from their inner ends, adjacent the die, to the outer ends of the leads. The respective lengths of these leads will also show a large difference.

In addition, the generally parallel spacing and long coupling lengths between the leads, which extends all the way to the outside perimeter of the package, can result in coupling of the signals on adjacent leads. Varying widths among these leads means that characteristic impedance levels are not controlled and matched which can result in signal reflection. The varying of the lead lengths may result in differences in signal propagation delay. In our U.S. Patent 4,801,999 there is shown a lead assembly in which leads and busses are arranged on both sides of a dielectric layer. However, the leads are still arranged around the die in generally parallel configuration to adjacent leads.

EP-A-0,026,807 discloses a multilayer structure with 7 conductor planes in which two signal lines are interleaved between a ground line and a voltage supply line in each conductor plane. In addition, the signal lines in two adjacent conductor planes are staggered from one another with the object of providing a uniform symmetrical alignment of the signal lines to the ground and the voltage supply lines respectively. This gives the module a constant characteristic impedance. The conductors of two superposed signal line planes are also arranged orthogonally to each other to minimize coupling between them.

IBM Technical Disclosure Bulletin, Vol. 20, No. 8, January 1978, pp 3092-3093 also shows signal lines interleaved between power lines 24 in each conductor plane of a multilayer structure, the lines in one plane being orthogonal to the lines in the adjacent plane to minimize noise coupling. The bond pads associated with the semiconductor chips on top of the package are connected to the various signal lines and power lines by a "fanout metallurgy pattern" with vias which extend through a dielectric layer supporting the pads.

EP-A-0,166,289 shows a multilayer structure with two different types of conductor planes. The upper R-planes have signal lines in a rectangular pattern, and the lower D-planes have signal lines in a diagonal pattern. High density wiring is achieved by reducing the number of vias extending to the D-planes so that more signal lines can be included in the D-planes between the remaining vias.

It would be an advantage if coupling and crosstalk between adjacent leads could be reduced in an integrated circuit lead assembly structure wherein an array of bonding pads is rectangularly disposed about a central die-mounting portion of a generally rectangular pc board, and wherein a plurality of leads extend from the respective bonding pads to the respective edges of the board.

According to the present invention, this is achieved by a lead assembly structure as defined in claims 1 and 3.

Preferably capacitive-loading networks in the form of side paths extending from the leads are provided on at least a portion of the leads to electrically compensate for uneven lead lengths by equalizing signal propagation delays.

In the accompanying drawings, by way of example only:

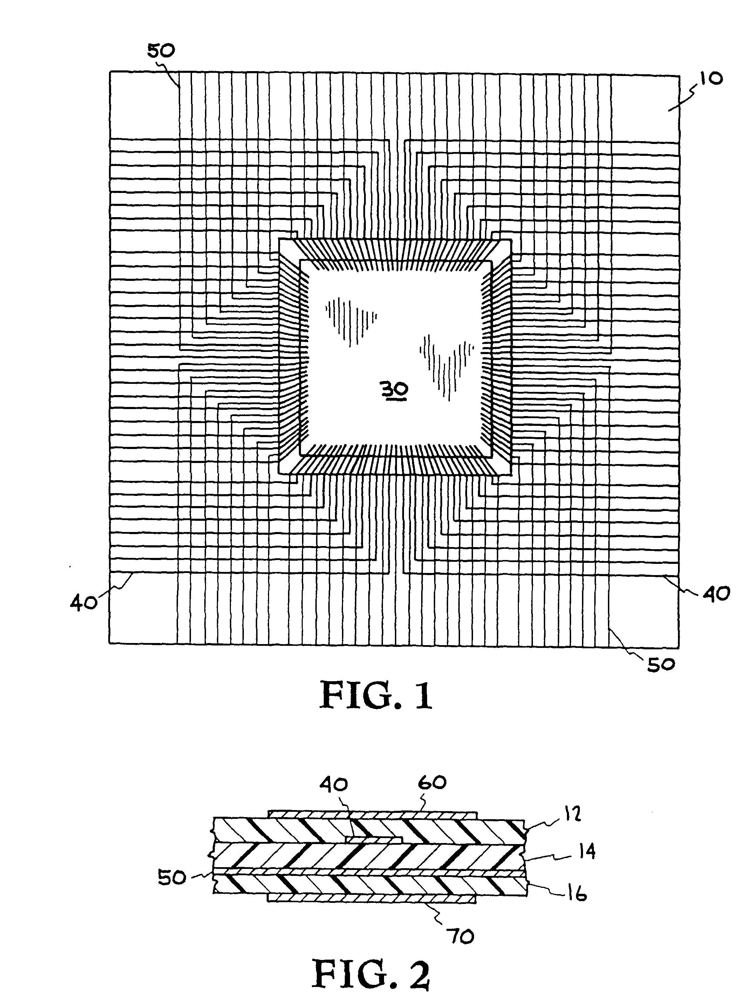

Figure 1 is a top view generally showing a lead assembly structure as it would be viewed from the top with a transparent pc board so that leads disposed on opposite surfaces of the pc board can be seen.

Figure 2 is a fragmentary side section view of the lead assembly structure shown as a laminate comprising a plurality of pc boards with a power electrode on the top surface of the laminate, a portion of a first lead pattern adjacent a second surface of the laminate, a portion of a second lead pattern adjacent a third surface of the laminate, and a ground electrode on the bottom surface of the laminate.

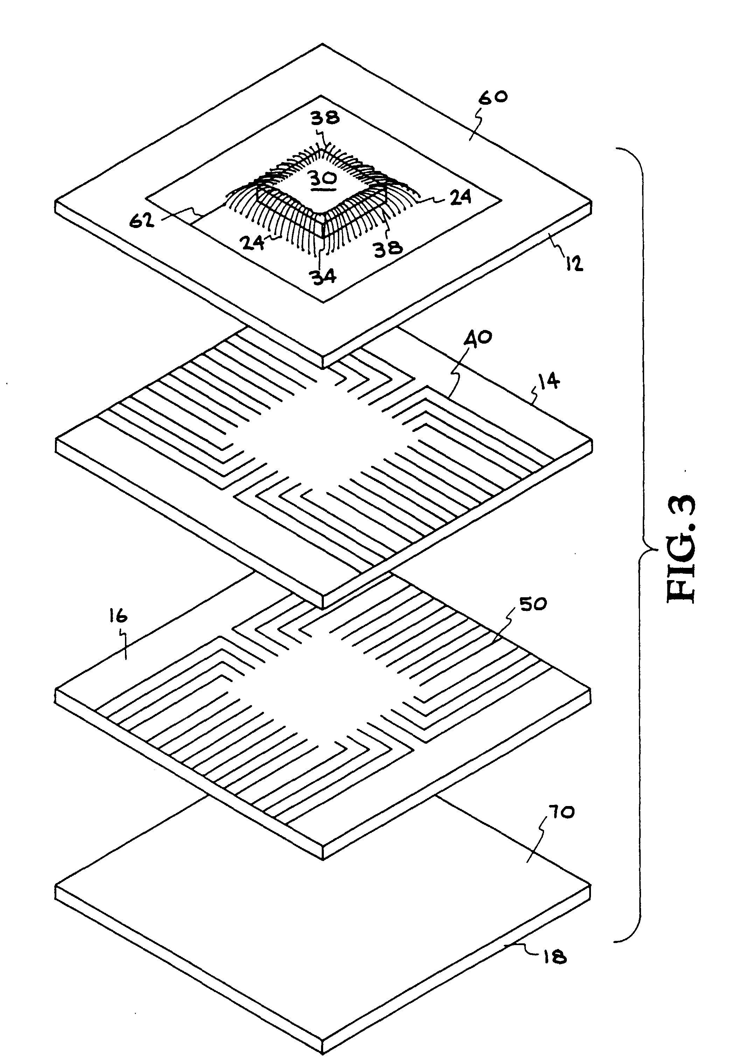

Figures 3 is an exploded view showing a lead assembly structure as a four layer laminate with a power electrode on the top surface, as well as a central die mounting area and a rectangular array of bonding pads surrounding the die mounting area, a first lead pattern formed on the top surface of a second pc board, a second lead pattern formed on the top surface of a third pc board, and a ground electrode which is shown formed (for illustration purposes only) on the top surface of a fourth pc board, it being understood that the ground electrode would normally be formed on the bottom surface of the third pc board to eliminate the need for use of a fourth pc board.

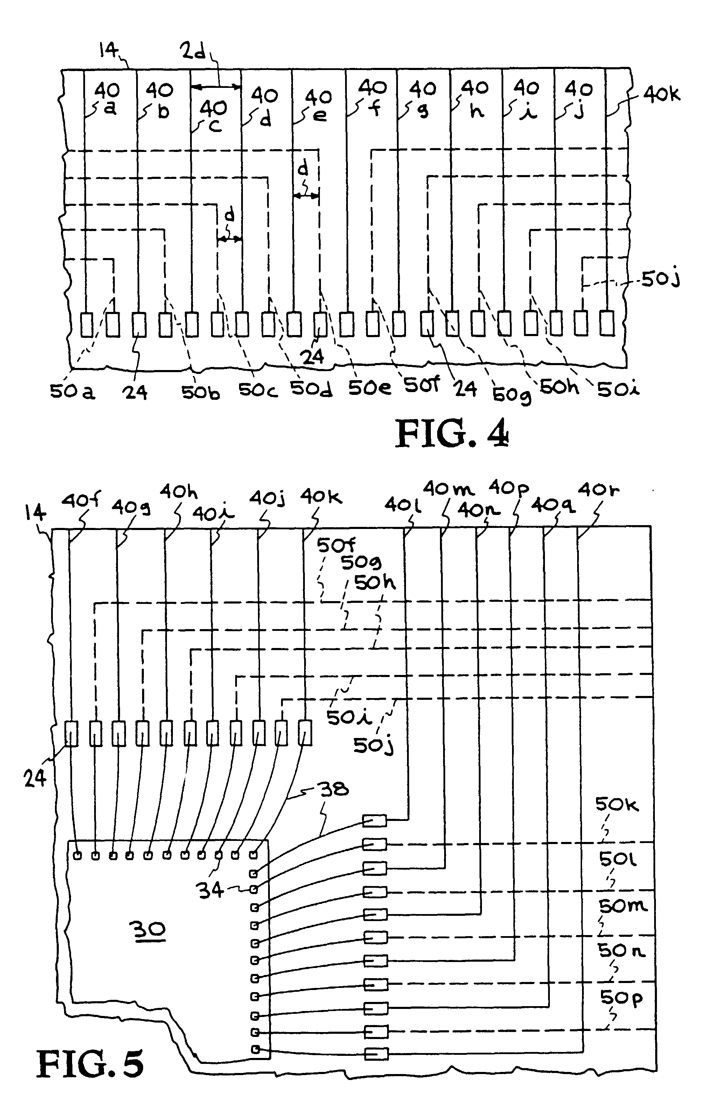

Figure 4 is a fragmentary top view of a portion of the surface of the lead assembly structure showing one side of the structure having the first lead pattern mounted adjacent the top surface of a pc board with a second lead pattern located beneath the pc board and outlined in dotted lines to show the relationship between the leads in the respective lead patterns.

Figure 5 is another fragmentary top view of a portion of the surface of the lead assembly structure showing portions of two sides of the structure having the first lead pattern mounted adjacent the top surface of a pc board with a second lead pattern located beneath the pc board and outlined in dotted lines to show the relationship between the leads in the respective lead patterns, and in particular how the leads on one pattern terminate on opposite end edges of the structure adjacent to the edges on which the leads in the second pattern terminate.

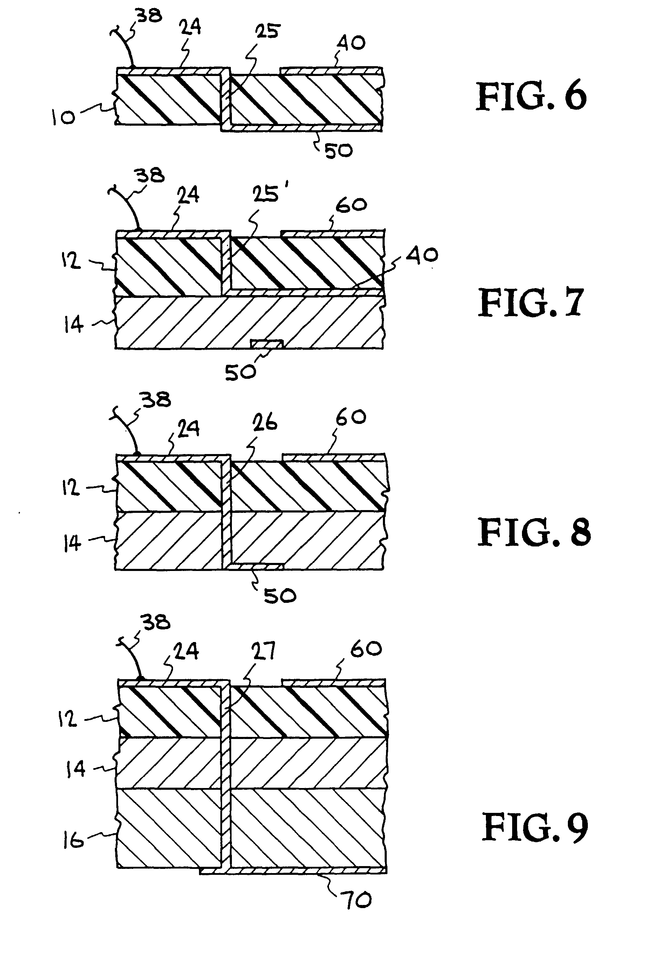

Figure 6 is a fragmentary side section view showing a lead of the first lead pattern on the top surface of a pc board as well as a bonding pad with a via extending through the pc board to provide electrical connection between the bonding pad and a lead from the second lead pattern shown disposed adjacent the opposite surface of the pc board.

Figure 7 is a fragmentary side section view showing a laminate of two pc boards with a Vcc electrode on the top surface of the first pc board, as well as a bonding pad with a via extending through the first pc board to provide electrical connection between the bonding pad and a lead from a first lead pattern shown disposed adjacent the top surface of a second pc board, and also showing a portion of a lead of a second lead pattern adjacent the bottom surface of the second pc board.

Figure 8 is a fragmentary side section view of the laminate of Figure 7 taken at a different point to show another bonding pad electrically connected to a via which extends through both pc boards to provide electrical connection between the bonding pad and a lead from the second lead pattern shown disposed adjacent the bottom surface of the second pc board.

Figure 9 is a fragmentary side section view showing a laminate of three pc boards with a power electrode on the upper surface of the uppermost pc board, a lead from a first lead pattern shown disposed adjacent the top surface of a second pc board, a portion of a lead of a second load pattern disposed adjacent the top surface of a third pc board, and a bonding pad also disposed on the upper surface of the top pc board and electrically connected to a via or plated through hole which extends through all the pc boards to provide electrical connection between the bonding pad and a power electrode on the bottom surface of the third pc board.

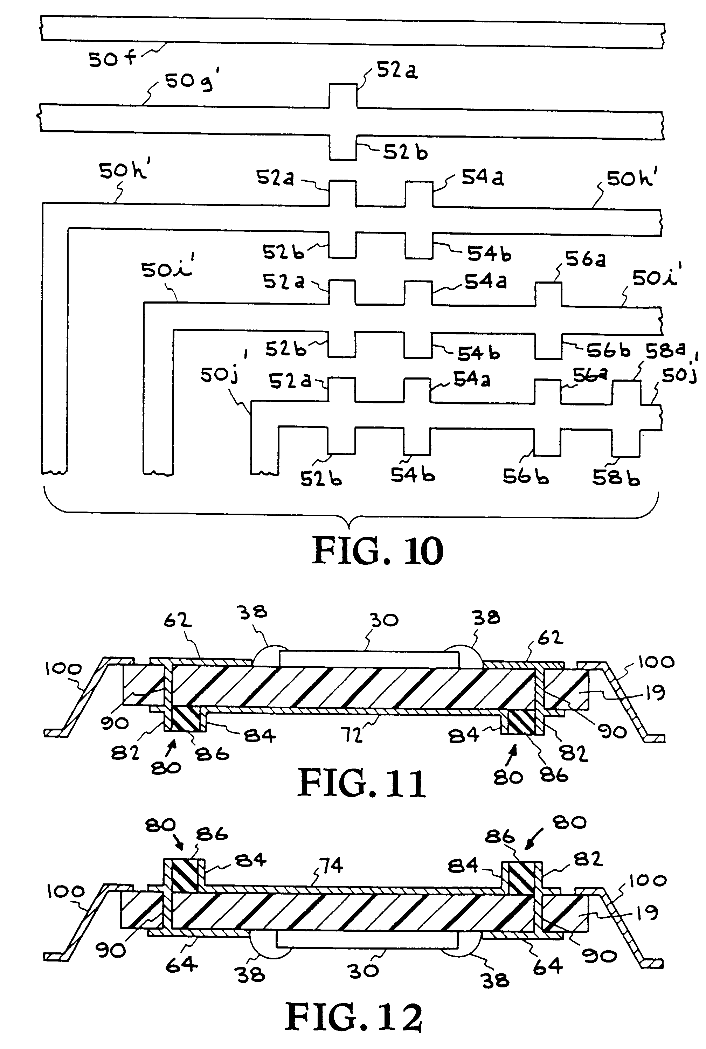

Figure 10 is a fragmentary top view of an advantageous embodiment of the invention wherein several adjacent leads of one lead pattern are shown with structural modifications to electrically compensate for the difference in lead lengths between leads.

Figure 11 is a side section view of another alternative wherein the lead assembly structure is shown with a die mounted on the top surface of the lead assembly structure and decoupling capacitor means mounted to the opposite surface of the lead assembly structure and electrically connected between the power and ground electrodes to reduce power supply voltage transients.

Figure 12 is a side second view of another embodiment of the invention wherein the die and the decoupling capacitor means are mounted on opposite sides of the lead assembly structure from the mounting shown in Figure 11.

Referring to Figure 1, a lead assembly structure embodying the invention is shown in its simplest form comprising a single pc board 10 having a first lead pattern 40 formed on the upper surface of pc board 10 and a second lead pattern 50 formed on the lower surface of pc board 10. For illustration purposes only, pc board 10 is illustrated in Figure 1 as transparent so that both lead patterns 40 and 50 can be seen.

It will be seen that lead pattern 40 is configured so that all of the leads extend to two opposite edges of the upper surface of pc board 10 while lead pattern 50 is configured so that all of the leads extend to the other two edges of pc board 10. In doing so all of the leads in lead pattern 40 (except for the middle lead shown on each opposite side in Figure 1) cross one or more leads in lead pattern 50 at a 90° angle and likewise all of the leads in lead pattern 50 (except for the middle lead shown on each opposite side in Figure 1) cross at least one lead in lead pattern 40 at a 90° angle. This 90° lead crossing between the leads of the two lead patterns reduces the coupling between adjacent leads as will be discussed below with regard to Figures 4 and 5.

The pc board 10, or any of the other pc boards to be discussed below, may be constructed of insulating plastic materials such as polyimides or any other equivalent plastic material, or they may comprise ceramic materials. The metals used to form the lead patterns on the pc boards may comprise any conductive metal which is compatible with the other materials used in the assembly or in the encapsulation materials. Aluminum or copper are conventionally used as lead pattern materials because of their conductivity, although gold or silver or other precious metals may also be used if the added expense of the use of such materials is justified in a particular application.

Referring now to Figure 2 and 3, another embodiment of the invention is shown wherein a plurality of pc boards have been used to form a laminate having a solid power electrode 60, e.g., a Vcc or Vdd power bus, formed on the upper surface of top pc board 12, lead pattern 40 formed either on the top surface of a second pc board 14 or on the lower surface of pc board 12, lead pattern 50 formed either on the top surface of a third pc board 16 or on the lower surface of pc board 14, and a solid ground electrode, e.g., a Vee or Vss ground bus, formed on the lower surface of pc board 16 (as shown in Figure 2) or on the upper surface of a fourth pc board 18 (as shown in Figure 3). While power and ground electrodes 60 and 70 and lead patterns 40 and 50 would normally be formed on the respective surfaces of three pc boards, a fourth board could be utilized and has been used in Figure 3 for illustrative purposes.

Still referring to Figure 3, die 30 is shown centrally mounted on pc board 12 and having a number of bonding pads 34 arranged around the periphery of die 30 which are connected by leads 38 to corresponding bonding pads 24 arranged in rectangular fashion around die 30 on the upper surface of pc board 12. A lead 62 is shown which, in turn, connects one of the bonding pads 24 with power electrode 60. While several of the bonding pads on die 30 may be connected through an appropriate bonding pad 24 in this manner to power bus electrode 60, the remainder of bonding pads 24 communicate respectively with the leads in lead patterns 40 and 50, as well as with ground lead electrode 70 through vias or plated through holes formed in the pc boards as will be discussed below with respect to Figures 6-9.

Turning now to Figures 4 and 5, the crossing of the leads in patterns 40 and 50 is shown wherein leads 40a-40r are shown as solid lines while leads 50a-50p are shown as dotted lines. As shown in both figures, the respective adjacent leads 40 and 50, e.g., leads 40f and 50f, are electrically connected to alternating adjacent bonding pads 24 on pc board 12. Such adjacent leads then extend out from the respective bonding pads 24 generally parallel to one another (but on opposite surfaces of pc board 14 and therefore spaced apart by the thickness of pc board 14). However, then one of the lines, e.g., lead 50f, turns at a right angle and then extends in the new direction to the edge of pc board 14, crossing, in the mean time, other leads in lead pattern 40, e.g., leads 40g-40k.

It will, of course, be understood, that the leads in respective lead patterns 40 and 50 do not physically cross one another since the respective lead patterns are separated from one another by the thickness of pc board 14. However, the leads do cross one another from the standpoint of the electrical coupling between adjacent leads which, but for such electrical crossing, would occur if the leads extended parallel to one another for their entire distance, even though separated from one another by pc board 14, since pc board 14 would simply act as the dielectric between the electrodes, i.e., function as the dielectric in a capacitive coupling between the electrodes.

By providing such 90° turns in the respective leads, all of the leads in lead pattern 40 will extend to two opposite edges of pc board 14 while all of the leads in lead pattern 50 will extend to the other two opposite edges of pc board 14 as best seen in Figure 5 wherein all of the leads 40f-40r in lead pattern 40 are shown (after the 90° turns of leads 401-40r) running vertical to the top edge of pc board 14 in Figure 5 while all of the leads 50f-50p in lead pattern 50 are shown (after the 90° turns of leads 50f-50j) extending horizontally to the side edge of pc board 14.

It will be further noted that the lead assembly of Fig. 5 provides additional spacing between adjacent leads extending to any edge of the pc board. Thus, for example, where the spacing between leads 50c and 40d, when they first extend out from their respective vias or plated-through holes connecting them to adjacent bonding pads, is shown in Figure 4 to be a distance d. However, the pitch between leads 40c and 40d, which leads extend parallel to one another to the edge of the pc board, is twice this distance, i.e., 2d. This additional spacing between the leads in lead pattern 40 - or the adjacent leads in lead pattern 50 - further serves to reduce the coupling and crosstalk between adjacent leads. Thus, for example, when leads having a width of 0.179mm (7 mils) are used with a conventional pitch of d = 0.317mm (12.5 mils), the effective doubling of this spacing, using the lead assembly structure of the invention, provides a 0.635mm (25 mil) spacing between adjacent leads in the same lead pattern.

It should also be noted that the effective doubling of the space between adjacent leads provides further freedom to adjust the lead width which is the controlling factor to impedance matching of the leads.

In Figures 6-9, there is shown contact being made from bonding pads 24 to the leads and/or electrodes not on the top surface of the assembly by the use of vias or plated-through holes which extend down through one or more pc boards to make electrical contact with the respective leads and/or electrodes. As is well known to those skilled in the art, a via is a hole or bore which is filled with a conductive material, e.g., aluminum.

Figures 6 illustrates the use of a single pc board with lead pattern 40 disposed on the top surface of pc board 10 and lead pattern 50 on the bottom surface. A via or plated-through hole 25, which extends through pc board 10, provides electrical contact between bonding pad 24 and a lead in lead pattern 50.

Figure 7 illustrates the use of vias or plated-through holes in a laminate comprising 2 pc boards with a power electrode 60 on the top surface of upper pc board 12, lead pattern 40 disposed between upper pc board 12 and lower pc board 14 (by either forming lead pattern 40 on the underside of pc board 12 or on the top surface of pc board 14), and lead pattern 50 on the undersurface of pc board 14. A via 25' extends through upper pc board 12 to make contact with a lead of lead pattern 40.

In Figure 8 another two layer laminate is shown with a power electrode 60 on the top surface of upper pc board 12. In this case lead pattern 40, although present, is not visible in the cross-section shown. A via or plated-through hole 26 is shown extending through both upper pc board 12 and lower pc board 14 to make contact between another bonding pad 24 and a lead of lead pattern 50.

Figure 9 shows a 3 layer laminate with a power electrode 60 on the top surface of pc board 12 and a ground electrode 70 on the bottom surface of pc board 16. Lead pattern 40 (not visible in this cross-section) is disposed between pc board 12 and pc board 14, while lead pattern 50 (also not visible in the particular cross-section) may be disposed between pc board 14 and pc board 16. A via or plated-through hole 27 extends from a bonding pad 24 down through all 3 layers or boards to make electrical contact with ground electrode 70.

Figure 10 illustrates an alternate or supplemental embodiment of the invention wherein the electrical imbalance created by the uneven lengths of the leads in the respective lead patterns are compensated for by providing small side lead paths forming capacitive-loading networks which electrically act as extensions of the lead path. Such extensions may be used on either lead patterns 40 or 50 or preferably, will be used on both lead patterns.

Thus, lead 50f, corresponding to lead 50f shown in Figures 4 and 5, is the longest lead in the illustrations and is, therefore, not shown with any lead path extenders. Lead 50g', the next shorter lead is provided, in this embodiment, with a single lead path extender comprising side portions 52a and 52b which extend the effective electrical length or path to balance the path with the longer path of lead 50f. In similar fashion, lead 50h' is provided with path extenders 52a and 52b as well as extenders 54a and 54b, while lead 50i' is provided with three lead path extenders, 52a and 52b, 54a and 54b, and 56a and 56b. Lead 50j', the shortest lead in the illustration, is provided with lead extensions 52a and 52b, 54a and 54b, 56a and 56b, and 58a and 58b.

Turning to Figures 11 and 12, yet another embodiment is shown wherein decoupling capacitors 80, comprising first electrode 82 and second electrode 84 separated by dielectric 86 may be mounted directly to a pc board laminate 19 with capacitor electrode 84 in direct electrical communication with ground electrode 72 in Figure 11 or ground electrode 74 in Figure 12. The other electrode 82 of capacitor 80 communicates with power line 62 in Figure 11 or power line 64 in Figure 12 through a via or plated-through hole 90 which passes through pc laminate 19. The intermediate layers and the lead patterns thereon have not been shown in Figures 11 and 12 for the sake of clarity and simplicity.

The basic difference between Figure 11 and Figure 12 is the mounting of die 30 either on the top surface of pc laminate 19, as shown in Figure 11 or the bottom surface, as shown in Figure 12. In either case, for convenience, capacitors 80 are mounted on the opposite surface from the mounting of die 30. In either case, as shown by holding brackets or jigs 100, the use of a pc board laminate, permits the mounting of capacitors 80 thereto prior to encapsulating the entire structure in a plastic material such as, for example, an epoxy or polyimide material.

Thus, the use of such a pc board laminate permits the use of decoupling capacitors in plastic-encapsulated integrated circuit structures where previously there was no place to mount the capacitor prior to encapsulation. It should be noted, however, that any of the described integrated circuit lead assemblies may be used with either plastic or ceramic packaging.

The lead assembly structures shown in the drawings thus provide a lead arrangement wherein crosstalk or coupling between adjacent leads is minimized or eliminated by the placement of leads from adjacent bonding pads on opposites sides of a pc board and by the crossing of such adjacent leads at right angles to one another as well as by the additional lead spacing made possible by such use of two lead patterns with right angle crossing of the leads in the respective lead patterns. Furthermore, the use of only a single bend in each trace, as compared to multiple conventional bends which sometimes occur in some traces to conserve space, minimizes discontinuities and signal reflections.

## Claims

1. An integrated circuit lead assembly structure comprising an array of bonding pads (24) rectangularly disposed about a central die-mounting portion of a generally rectangular pc board (10). and a plurality of leads extending from the respective bonding pads to the respective edges of the board. the leads forming a first lead pattern (40) on one surface of the board and a second lead pattern (50) on the opposite surface of the board, wherein
the first lead pattern (40) consists of:
(a) generally straight leads extending in parallel from alternate bonding pads (24) on two opposite sides of the rectangular array, and
(b) leads initially, extending in parallel from alternate bonding pads (24) on the other two sides of the rectangular array and then turning at right angles in staircase fashion to extend parallel to one another and parallel to the leads extending from the first two opposite sides of the array, and
the bonding pads (24) disposed between the said alternate bonding pads (24) are electrically connected through the pc board (10) to respective leads of the second lead pattern (50). the second lead pattern (50) consisting of leads extending from the bonding pads (24) in a similar pattern to the first lead pattern (40) but with the second pattern rotated through 90 degrees with respect to the first pattern (40) whereby the leads in the second pattern (50) are disposed at 90 degrees to the leads in the first pattern (40) along at least a portion of their lengths so as to reduce crosstalk and coupling between the leads.

2. An integrated circuit lead assembly structure as claimed in claim 1, wherein capacitive-loading networks are provided on at least a portion of said leads to electrically compensate for uneven lead lengths by equalising signal propagation delays, said capacitive-loading networks being formed by one or more side paths (52a, 52b, 54a, 54b. 56a, 56b) extending from the respective leads.

3. An integrated circuit lead assembly structure comprising a laminate of two or more generally rectangular pc boards (12, 14, 16, 18) having surfaces lying in parallel planes so that any two neighbouring surfaces are separated by a layer of insulating material forming a respective pc board; at least one power or ground electrode (60, 70) positioned on a first of the said surfaces of a first of the pc boards; a first lead pattern (40) positioned on a second of the said surfaces; a second lead pattern (50) positioned on a third of the said surfaces: and an array of bonding pads (24) rectangularly disposed about a central die-mounting portion (30) of the first of the pc boards 12), the bonding pads (24) being electrically connected to respective leads of the first lead pattern (40) through the said first of the pc boards (12) in the laminate and to respective leads of the second lead pattern through the first (12) and a second (14) of the pc boards. the first and second lead patterns (40. 50) comprising a plurality of leads extending from the respective bonding pads to the respective edges of the laminate. wherein
the first lead pattern (40) consists of:
(a) generally straight leads extending in parallel from alternate bonding pads (24) on two opposite sides of the rectangular array, and
(b) leads initially extending in parallel from alternate bonding pads (24) on the other two sides of the rectangular array and then turning at right angles in staircase fashion to extend parallel to one another and parallel to the leads extending from the first two opposite sides of the array;
the second lead pattern (50) consists of leads extending from the bonding pads (24) disposed between the said alternate bonding pads in a similar pattern to the first lead pattern (40) but with the second pattern rotated through 90 degrees with respect to the first pattern (40) whereby the leads in the second pattern (50) are disposed at 90 degrees to the leads in the first pattern (40) along at least a portion of their lengths so as to reduce crosstalk and coupling between the leads; and
at least one bonding pad (24) is electrically connected respectively with the said at least one power or ground electrode (60, 70), the connection being made from the respective bonding pad through the laminate of boards (12, 14, 16, 18).

4. An integrated circuit lead assembly structure as claimed in claim 3, comprising at least three pc boards and having another power or ground electrode (60, 70) positioned on a fourth of the said surfaces.

5. An integrated circuit device comprising an integrated circuit lead assembly structure as claimed in claim 3 or claim 4, wherein an integrated circuit die (30) is mounted on the central die-mounting portion of the first pc board (10), the die having a rectangular array (34) of bonding pads thereon; and wherein the bonding pads (34) on the die (30) are electrically connected respectively to the said array of bonding pads (24) disposed about the central die-mounting portion of the first pc board (10).

6. An integrated circuit device as claimed in claim 5 when dependent on claim 4, wherein decoupling capacitor means (80) are mounted on one outer surface of the laminate and electrically connected between said power and ground electrodes to reduce power supply voltage transients. said outer surface being opposite to the said first surface.

## Patentansprüche

1. IC-Anschlußleitungs-Struktur mit einem Array von Verbindungsfeldern (24), die rechtwinklig um einen zentralen Chipbefestigungsabschnitt einer im wesentlichen rechteckigen pc-Platine (10) angeordnet sind, und mehreren Leitern, die von den jeweiligen Verbindungsfeldern zu den jeweiligen Rändern der Platine verlaufen, wobei die Leiter auf einer Fläche der Platine ein erstes Leitermuster (40) bilden und auf der entgegengesetzten Fläche der Platine ein zweites Leitermuster (50) bilden, wobei
das erste Leitermuster (40) aufweist:
(a) im wesentlichen geradlinige Leiter, die parallel von alternierenden Verbindungsfeldern (24) an zwei entgegengesetzten Seiten des rechtwinkligen Arrays ausgehen, und
(b) Leiter, die zunächst parallel von alternierenden Verbindungsfeldern (24) an den anderen beiden Seiten des rechtwinkligen Arrays ausgehen und dann rechtwinklig nach Art einer Treppe derart abbiegen, daß sie parallel zueinander und parallel zu den von ersten beiden entgegengesetzten Seiten des Array ausgehenden Leitern verlaufen, und
wobei die zwischen den beiden Verbindungsfeldern (24) angeordneten Verbindungsfelder (24) durch die pc-Platine (10) elektrisch mit jeweiligen Leitern des zweiten Leitermusters (50) verbunden sind, und das zweite Leitermuster (50) aus Leitern besteht, die von den Verbindungsfeldern (24) in einer dem ersten Leitermuster (40) ähnlichen Weise ausgehen, wobei jedoch das zweite Muster relativ zu dem ersten Muster (40) um 90 Grad gedreht ist, wodurch die Leiter in dem zweiten Muster (50) entlang mindestens eines Abschnitts ihrer Länge gegenüber den Leitern in dem ersten Muster (40) unter einem Winkel von 90 Grad angeordnet sind und dadurch ein Übersprechen und eine Kopplung zwischen den Leitern reduzieren.

2. IC-Anschlußleitungs-Struktur nach Anspruch 1, bei dem mindestens an einem Abschnitt der Leiter Kapazitivlast-Netzwerke vorgesehen sind, die ungleiche Leiter-Längen mittels Ausgleichen von Signalausbreitungsverzögerungen elektrisch kompensieren, wobei die Kapazitivlast-Netzwerke durch einen oder mehrere Seitenpfade (52a,52b,54a,54b,56a,56b) gebildet sind, die von den jeweiligen Leitern ausgehen.

3. IC-Anschlußleitungs-Struktur mit einem Laminat aus zwei oder mehr im wesentlichen rechteckigen pc-Platinen (12, 14,16,18) mit Flächen, die derart in parallelen Ebenen liegen, daß jedwede zwei benachbarten Flächen durch eine Schicht aus Isoliermaterial getrennt sind, die eine jeweilige pc-Platine bildet; mindestens einer Leistungs- oder Masse-Elektrode (60,70), die an einer ersten der Flächen einer ersten der pc-Platinen positioniert ist; einem ersten Leitermuster (40), das an einer zweiten der Flächen positioniert ist; einem zweiten Leitermuster (50), das an einer dritten der Flächen positioniert ist; und einem Array von Verbindungsfeldern (24), die rechtwinklig um einen zentralen Chipbefestigungsabschnitt (30) der ersten der pc-Platinen (10) angeordnet sind, wobei die Verbindungsfelder (24) durch die erste der pc-Platinen (12) in dem Laminat elektrisch mit jeweiligen Leitern des ersten Leitermusters (40) verbunden sind und durch die erste (12) und eine zweite (14) der pc-Platinen elektrisch mit jeweiligen Leitern des zweiten Leitermusters verbunden sind, wobei die ersten und zweiten Leitermuster (40,50) mehrere Leiter aufweisen, die von den jeweiligen Verbindungsfeldern zu den jeweiligen Rändern des Laminats verlaufen, wobei
das erste Leitermuster (40) aufweist:
(a) im wesentlichen geradlinige Leiter, die parallel von alternierenden Verbindungsfeldern (24) an zwei entgegengesetzten Seiten des rechtwinkligen Arrays ausgehen, und
(b) Leiter, die zunächst parallel von alternierenden Verbindungsfeldern (24) an den anderen beiden Seiten des rechtwinkligen Arrays ausgehen und dann rechtwinklig stufenweise derart abbiegen, daß sie parallel zueinander und parallel zu den von ersten beiden entgegengesetzten Seiten des Array ausgehenden Leitern verlaufen, und
wobei das zweite Leitermuster (50) Leiter aufweist, die von den zwischen den alternierenden Verbindungsfeldern angeordneten Verbindungsfeldern (24) in einer dem ersten Leitermuster (40) ähnlichen Weise ausgehen, wobei jedoch das zweite Muster relativ zu dem ersten Muster (40) um 90 Grad gedreht ist, wodurch die Leiter in dem zweiten Muster (50) entlang mindestens eines Abschnitts ihrer Länge gegenüber den Leitern in dem ersten Muster (40) unter einem Winkel von 90 Grad angeordnet sind und dadurch ein Übersprechen und eine Kopplung zwischen den Leitern reduzieren; und
wobei mindestens ein Verbindungsfeld (24) jeweils mit der mindestens einen Leistungs- oder Masse-Elektrode (60,70) elektrisch verbunden ist, wobei die Verbindung von dem jeweiligen Verbindungsfeld durch das Platinen-Laminat (12,14,16,18) erfolgt.

4. IC-Anschlußleitungs-Struktur nach Anspruch 3, mit mindestens drei IC-Platinen und mit einer weiteren Leistungs-oder Masse-Elektrode (60,70), die mit einer vierten der Flächen verbunden ist.

5. IC-Einrichtung mit einer IC-Anschlußleitungs-Struktur nach Anspruch 3 oder Anspruch 4, bei der ein IC-Chip (30) an dem zentralen Chipbefestigungsabschnitt der ersten pc-Platine (10) befestigt ist, wobei an dem Chip ein rechteckiges Array (34) von Verbindungsfeldern befestigt ist; und bei der die Verbindungsfelder (34) auf dem Chip (30) jeweils mit dem Array von Verbindungsfeldern (24), die um den zentralen Chipbefestigungsabschnitt der ersten pc-Platine (10) angeordnet sind, elektrisch verbunden sind.

6. IC-Einrichtung nach Anspruch 5 in Abhängigkeit von Anspruch 4, bei der Entkopplungskondensatoreinrichtungen (80) an einer Außenfläche des Laminats befestigt sind und elektrisch zwischen die Leistungs- und Masse-Elektroden geschaltet sind, um Versorgungsstrom-Spannungssprünge zu reduzieren, wobei die Außenfläche der ersten Fläche entgegengesetzt ist.

## Revendications

1. Structure d'assemblage de conducteurs pour circuit intégré comprenant un réseau de plots de connexion (24) disposés en rectangle autour d'une partie centrale de montage de dé d'une plaquette de c.i., généralement rectangulaire (10), et une pluralité de conducteurs s'étendant des plots de connexion respectifs vers les bords respectifs de la plaquette, les conducteurs formant une première configuration de conducteurs (40) sur une surface de la plaquette et une seconde configuration de conducteurs (50) sur la surface opposée de la plaquette, dans laquelle :
la première configuration de conducteurs (40) comporte :
(a) des conducteurs généralement rectilignes s'étendant parallèlement à partir des plots de connexion alternés (24) sur deux côtés opposés du réseau rectangulaire , et
(b) des conducteurs s'étendant initialement en parallèle à partir des plots de connexion alternés (24) sur les deux autres côtés du réseau rectangulaire et tournant, ensuite, à angle droit, en marche d'escalier, pour s'étendre parallèlement les uns aux autres et parallèlement aux conducteurs s'étendant à partir des deux premiers côtés opposés du réseau , et
les plots de connexion (24) disposés entre lesdits autres plots de connexion (24) alternés sont connectés électriquement à travers la plaquette de c.i. (10) aux conducteurs respectifs de la seconde configuration de conducteurs (50), la seconde configuration de conducteurs (50) étant constituée de conducteurs s'étendant à partir des plots de connexion (24) suivant une configuration similaire à la première configuration de conducteurs (40) mais la seconde configuration opérant une rotation de 90 degrés par rapport à la première configuration (40), de façon que les conducteurs de la seconde configuration (50) soient disposés à 90 degrés par rapport aux conducteurs de la première configuration (40) suivant au moins une partie de leurs longueurs, de façon à réduire couplage et couplage parasite entre les conducteurs.

2. Structure d'assemblage de conducteurs pour circuit intégré selon la revendication 1 , dans laquelle des circuits de charge capacitive sont prévus sur au moins une partie desdits conducteurs pour compenser électriquement une inégalité des longueurs de conducteurs en égalisant les retards de propagation du signal, lesdits circuits de charge capacitive étant formés par un ou plusieurs prolongements latéraux (52a, 52b, 54a, 54b,56a, 56b) s'étendant à partir des conducteurs respectifs.

3. Structure d'assemblage de conducteurs pour circuit intégré comprenant un stratifié de deux plaquettes de c.i., ou plus, généralement rectangulaires (12, 14, 16, 18) présentant des surfaces reposant dans des plans parallèles, de sorte que deux surfaces quelconques voisines sont séparées par une couche de matériau isolant formant une plaquette de c.i. respective ; une électrode au moins, d'alimentation ou de terre (60,70) positionnée sur une première desdites surfaces d'une première des plaquettes de c.i. ; une première configuration de conducteurs (40) formée sur une seconde desdites surfaces; une seconde configuration de conducteurs (50) formée sur une troisième desdites surfaces ; et un réseau de plots de connexion (24) disposé en rectangle autour d'une partie centrale de montage du dé (30) de la première des plaquettes de c.i. (12) , les plots de connexion (24) étant connectés électriquement aux conducteurs respectifs de la première configuration de conducteurs (40) à travers ladite première des plaquettes de c.i. (12) du stratifié et aux conducteurs respectifs de la seconde configuration de conducteurs à travers la première (12) et une seconde plaquette (14) des plaquettes de c.i., les première et seconde configurations de conducteurs (40,50) comprenant une pluralité de conducteurs s'étendant à partir des plots de connexion respectifs vers les bords respectifs du stratifié dans laquelle
la première configuration de conducteurs (40) comprend :
(a) des conducteurs généralement rectilignes s'étendant parallèlement à partir des plots de connexion alternés (24) sur deux côtés opposés du réseau rectangulaire , et
(b) des conducteurs s'étendant initialement en parallèle à partir des plots de connexion alternés (24) sur les deux autres côtés du réseau rectangulaire et, ensuite, tournant à angle droit, en marche d'escalier, pour s'étendre parallèlement les uns aux autres et parallèlement aux conducteurs s'étendant à partir des deux premiers côtés opposés du réseau ;
la seconde configuration de conducteurs (50) comprend des conducteurs s'étendant des plots de connexion (24) disposés entre lesdits plots de connexion alternés suivant une configuration similaire à la première configuration de conducteurs (40), mais la seconde configuration opérant une rotation de 90° par rapport à la première configuration (40), de sorte que les conducteurs de la seconde configuration (50) sont disposés à 90 degrés par rapport aux conducteurs de la première configuration (40) sur une partie au moins de leur longueur, de façon à réduire couplage et couplage parasite entre les conducteurs; et
un plot de connexion au moins (24) est connecté électriquement respectivement à ladite (aux dites) électrode(s) de terre ou d'alimentation (60,70), la connexion se faisant à partir du plot de connexion respectif à travers le stratifié de plaquettes (12, 14, 16, 18).

4. Structure d'assemblage de conducteurs pour circuit intégré selon la revendication 3 , comprenant au moins trois plaquettes de c.i. et comportant une autre électrode d'alimentation ou de terre (60, 70) placée sur une quatrième desdites surfaces.

5. Dispositif à circuit intégré comprenant une structure d'assemblage de conducteurs pour circuit intégré selon la revendication 3 ou 4 , dans lequel un dé de circuit intégré (30) est monté sur la partie centrale de montage de dé de la première plaquette de c.i. (10), le dé supportant un réseau rectangulaire de plots de connexion (34) ; et dans lequel les plots de connexion (34) disposés sur le dé (30) sont connectés électriquement, respectivement, audit réseau de plots de connexion (24) disposés autour de la partie centrale de montage de dé de la première plaquette de c.i. (10).

6. Dispositif à circuit intégré selon la revendication 5, lorsque dépendante de la revendication 4, dans lequel des moyens de condensateur de découplage (80) sont montés sur une surface extérieure du stratifié et connectés électriquement entre lesdites électrodes de terre et d'alimentation pour réduire les phénomènes transitoires de tension d'alimentation, ladite surface extérieure étant opposée à ladite première surface.
